# EUROPÄISCHE PATENTSCHRIFT

(11) **EP 1 588 928 B1**
(45) Veröffentlichungstag und Bekanntmachung des Hinweises auf die Patenterteilung: **03.11.2010**
(21) Anmeldenummer: 05005690.2
(22) Anmeldetag: 19.03.2005
(51) Int. Cl.: G01R 31/00, B62D 15/02

(54) **Verfahren und Vorrichtung zur Versorgung eines Sensors mit einer geregelten Sensorversorgungsspannung**
Method and device for supplying a sensor with a regulated sensor supply voltage
Procédé et dispositif d'alimentation d'un capteur à tension d'alimentation régulée

(30) Priorität: 16.04.2004 DE 102004018398
(43) Veröffentlichungstag der Anmeldung: 26.10.2005
(73) Patentinhaber: MAN Nutzfahrzeuge Aktiengesellschaft, 80995 München (DE)
(72) Erfinder: Kelle, Hans-Jochen, Dipl.-Ing., 80636 München (DE)

(56) Entgegenhaltungen:
- EP-A- 1 187 294
- DE-A1- 10 127 054
- GB-A- 2 318 935

## Beschreibung

Die Erfindung betrifft ein Verfahren und eine Vorrichtung zur Versorgung eines Sensors mit einer geregelten Sensorversorgungsspannung.

Sensoren, deren Betriebsspannung bzw. Versorgungsspannung niedriger ist als die von einer Spannungsquelle gelieferte Spannung, können beispielsweise über einen Spannungswandler versorgt werden. Hierdurch ist es möglich, die Sensoren an ein Netz anzuschließen, das eine höhere Spannung führt, als die Betriebsspannung des Sensors ist. Insbesondere beim Einbau von Sensoren mit einer Betriebsspannung von etwa 12V in einem Nutzfahrzeug, dessen Bordnetz eine höhere Spannung von etwa 24V führt, besteht die Gefahr von nicht erkennbaren Störungen, wie sie beispielsweise durch einen Kurzschluß im Kabelbaum infolge Verquetschungen oder durch ein Durchscheuern mit Nachbarleitungen verursacht werden. Die Fehlversorgung des Sensors kann zu dessen Zerstörung oder zur Abgabe falscher Sensorsignale führen.

Aus der DE 101 27 054 A1 ist ein gattungsgemäßes Verfahren zur Versorgung eines Sensors mit einer geregelten Sensorversorgungsspannung bekannt. Die von einem Versorgungsbaustein erzeugten Spannungen werden bei diesem Verfahren durch Bänder und Vorgabewerte auf Fehler überwacht. Für Spannungen, welche betragsmäßig innerhalb der Bänder liegen, sowie für Spannungen, welche diese Bänder betragsmäßig unterschreiten bzw. überschreiten, werden jeweils bestimmte Meldesignale erzeugt.

Aufgabe der Erfindung ist es, ein Verfahren und eine Vorrichtung der eingangs genannten Art zu schaffen, bei denen eine Überwachung der Versorgungsspannung, mit welcher der Sensor betrieben wird, verbessert wird.

Diese Aufgabe wird beim Verfahren durch die kennzeichnenden Merkmale des Patentanspruches 1 und bei der Vorrichtung durch die kennzeichnenden Merkmale des Patentanspruches 4 oder 5 gelöst.

Bei der Erfindung wird die Sensorversorgungsspannung, mit welcher der Sensor betrieben wird, erfasst, ausgewertet und unmittelbar als Meldesignal ausgegeben. Dabei wird mittels einer Auswerteeinrichtung, die als Logikschaltung ausgebildet sein kann, ein erstes Meldesignal bei einem Überschreiten eines vorbestimmten auf den Sensor abgestimmten Betriebsbereiches der Sensorversorgungsspannung abgegeben.

Bei Unterschreitung des vorbestimmten Betriebsbereiches der Sensorversorgung wird ein zweites Meldesignal abgegeben. Ein drittes Signal wird dann erzeugt, wenn die Sensorversorgungsspannung innerhalb des auf den Sensor abgestimmten Betriebsbereichs liegt.

Die Meldesignale werden in einer Meldeleitung übertragen, die zwischen der Auswerteeinrichtung und einem Steuergerät vorgesehen ist. Das Steuergerät wertet die beiden ersten Meldesignale für eine entsprechende Fehleranzeige und das dritte Meldesignal für den fortgesetzten Betrieb oder die Freigabe des Betriebs des Spannungswandlers und Sensors aus. Das Steuergerät kann noch die Funktion eines Prozessreglers, der die vom Sensor gelieferten Messwerte für Prozessgrößen auswertet, haben.

Aufgrund der so erzielten Überwachung der Sensorversorgungsspannung ist es beispielsweise möglich, 12V-Sensoren bei Nutzfahrzeugen mit 24V-Bordnetz zum Einsatz zu bringen. Aufgrund der bei der Erfindung erzielten Fehlererkennung, welche unmittelbar am Ausgang des Spannungswandlers stattfinden kann, erreicht man eine sichere Überwachung der Versorgung des Sensors und auch des Sensorbetriebs. Außerdem erreicht man mit Hilfe eines digitalen Fehlersignales eine Differenzierung der Fehlerquellen. Das erste Meldesignal besitzt einen High-Pegel, insbesondere den Pegel der Wandlerversorgungsspannung von beispielsweise etwa 24V und das zweite Meldesignal einen Low-Pegel, insbesondere etwa Masse (0 V)-Potential.

Das dritte Meldesignal wird mit Hilfe eines Frequenzgenerators zwischen den beiden Potentialen des ersten und zweiten Meldesignals, insbesondere zwischen Masse und dem Potential der Wandlerversorgung, getaktet sein.

Anhand der Figuren wird an einem Ausführungsbeispiel die Erfindung noch näher erläutert.

Es zeigt
- Fig. 1: ein Blockschaltbild einer Vorrichtung zur Spannungsversorgung eines Sensors, wel- cher einer Ausführungsbeispiel der Erfindung ist;
- Fig. 2: in Blockbilddarstellung einer überwachten Spannungswandlereinrichtung, welche beim Ausführungsbeispiel der Fig. 1 zum Einsatz kommt; und
- Fig. 3: in Blockbilddarstellung ein Steuergerät, welches beim Ausführungsbeispiel der Fig. 1 zum Einsatz kommt.

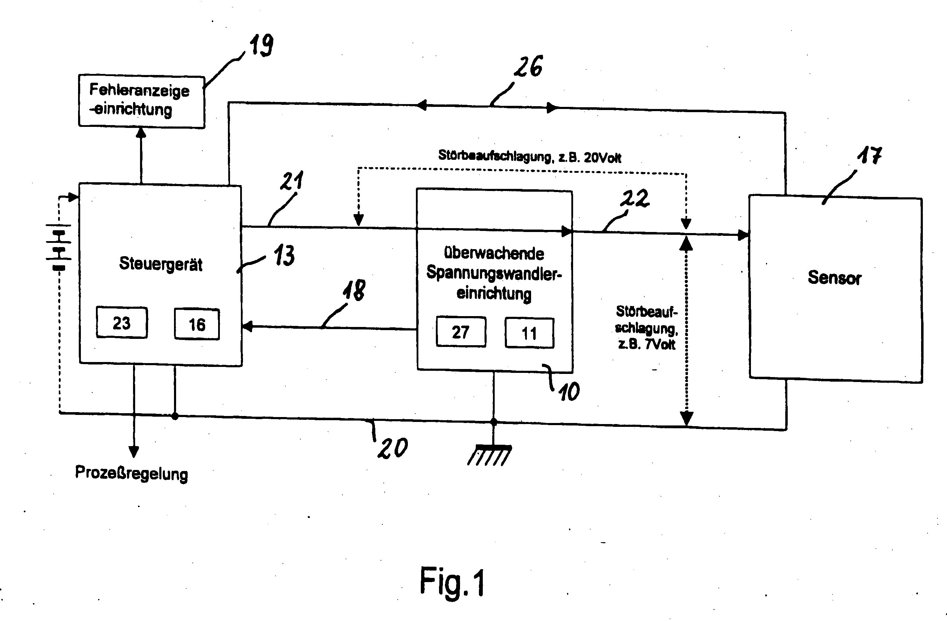

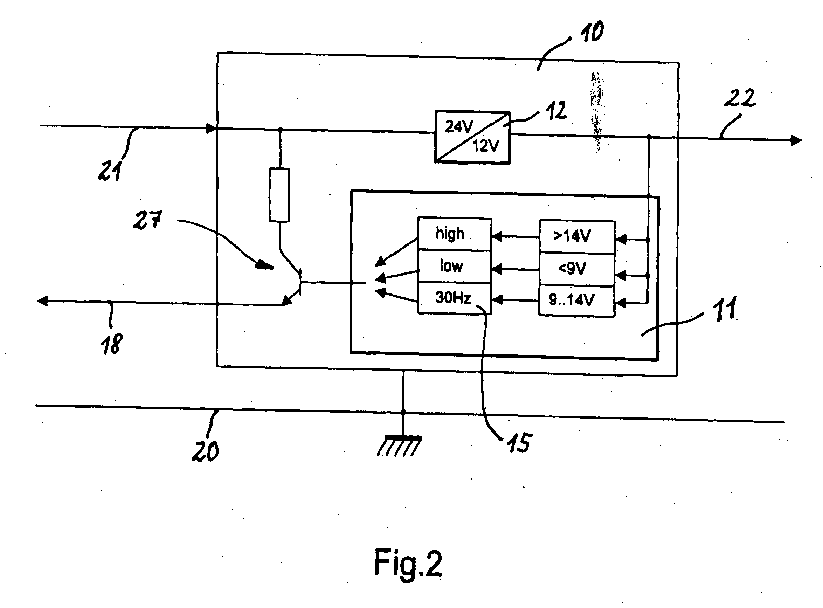

In der Fig. 1 ist als Blockschaltbild die gesamte Anordnung der Spannungsversorgung für einen Sensor 17 dargestellt. Der Sensor 17 dient beispielsweise zur Erfassung von Prozessgrößen. Insbesondere kann der Sensor 17 in einem Nutzfahrzeug, beispielsweise als Lenkwinkelsensor in einem Lenkstock, zum Einsatz kommen. Die für den Betrieb erforderliche Sensorversorgungsspannung wird über eine Sensorversorgungsleitung 22 geliefert. Mittels einer überwachenden Spannungswandlereinrichtung 10, welche einen vorzugsweise elektronisch geregelten Spannungswandler 12 (Fig. 2) aufweist, wird die Gleichspannung am Ausgang des Spannungswandlers 12 auf die für den Betrieb des Sensors 17 geeignete Spannung gebracht. Beispielsweise kann die Gleichspannung einen Wert von 24V haben, wie er an Bordnetzen von Nutzfahrzeugen üblich ist. Diese Netzspannung dient zur Versorgung des Spannungswandlers 12 und wird über eine Wandlerversorgungsleitung 21 geliefert. Der Spannungswandler 12 regelt die Gleichspannung auf 12V für den Betrieb des Sensors 17.

Der Sensor 17 ist über eine Sensorsignalleitung 26 bzw. Messgrößensiganlleitung 26 mit einem Steuergerät 13, welches auch die Funktion eines Prozessreglers haben kann, angeschlossen. Die vom Sensor 17 über eine Sensorsignalleitung 26 gelieferten Signale dienen zur Prozessregelung, beispielsweise beim Lenken eines Nutzfahrzeugs. Aufgrund der räumlichen Trennung des Sensors 17 vom Steuergerät 13 können sich Störungen bei der Sensorversorgung ergeben. Diese Störungen können durch Verquetschen oder Durchscheuern von Leitungen mit Nachbarleitungen oder auch durch falsches Verklemmen hervorgerufen werden. Dies kann beispielsweise dazu führen, dass die Sensorversorgungsspannung in der Sensorversorgungsleitung 22 durch Einflüsse aus der Wandlerversorgungsleitung 21 zu hoch ist und beispielsweise eine Störbeaufschlagung mit etwa 20V aufweist. Ferner kann die Sensorversorgungsspannung in der Leitung 22 zu niedrig, beispielsweise bei etwa 7V, sein. Derartige Störungen können infolge von Leitungsabrissen in der Wandlerversorgungsleitung 21, einer Masseleitung 20 und dergleichen hervorgerufen werden.

Um derartige Störungen zu erfassen, ist, wie aus der Fig. 2 zu ersehen ist, an den Ausgang des Spannungswandlers 12 eine Auswerteeinrichtung 11, welche eine Auswertelogikschaltung aufweist, angeschlossen. Für den Normalbetrieb des Sensors 17 ist ein Bereich der Versorgungsspannung vorgesehen, innerhalb welchem der Sensor 17 einwandfrei funktioniert. Bei einem 12V-Sensor kann dieser Bereich von beispielsweise 9V bis 14V reichen.

Wenn aufgrund einer Störung die Sensorversorgungsspannung beim dargestellten Ausführungsbeispiel > 14V ist, verursacht die Auswertelogik am Schaltausgang 27, der durch einen elektronischen Schalter realisiert ist, der Spannungswandlereinrichtung 10 in einer mit dem Schaltausgang 27 verbundenen Meldeleitung 18 ein erstes Meldesignal mit konstantem High-Pegel, welcher vorzugsweise der Wandlerversorgungsspannung 21 (24 V) entspricht. Wenn die Sensorversorgungsspannung in der Leitung 22 < 9 V ist, wird der Schaltausgang 27 von der Auswerteeinrichtung 11 derart angesteuert, dass die Meldeleitung 18 ein zweites Meldesignal mit Low-Pegel, vorzugsweise Masse (0 V)-Potential führt.

Wenn die Sensorversorgungsspannung innerhalb des Betriebsbereiches von 9V bis 14V liegt, wird der Steuereingang des Schaltausgangs 27 mittels eines Frequenzgenerators getaktet, so dass die Meldeleitung 18, beispielsweise mit 30 Hz, zwischen Massepotential und dem Potential der Wandlerversorgungsleitung 21 für ein drittes Meldesignal getaktet wird. Mit Hilfe der beschriebenen Auswertelogik erreicht man ohne Software die erforderliche Überwachung der Sensorversorgung.

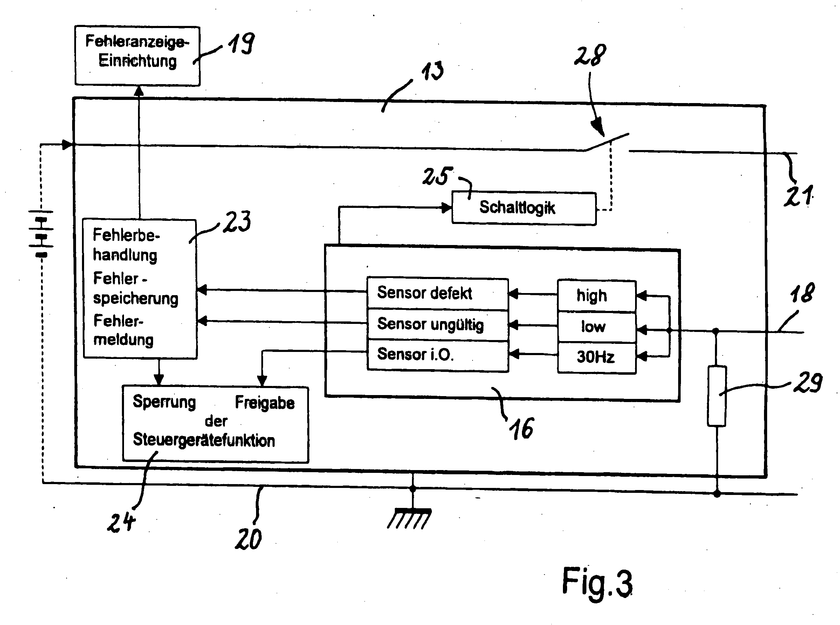

Die Meldeleitung 18 ist mit einer Auswerteeinrichtung 16 verbunden, die im Steuergerät 13 vorgesehen sein kann (Fig. 3). Die Meldeleitung 18 ist über einen Pulldown Widerstand 29 gegen Masse 20 geführt. Die Auswerteeinrichtung 16 ist vorzugsweise als digitale Auswertelogik zur Erfassung und Unterscheidung der in der Meldeleitung 18 gelieferten Meldesignale ausgebildet. Das erste Meldesignal, welches bei zu hoher Sensorversorgungsspannung geliefert wird, kann einen Hinweis auf einen defekten Sensor geben. In einem Speicher 23 für die Fehlerbehandlung wird an einem bestimmten Speicherplatz dieses Meldesignal gespeichert.

Falls das zweite Meldesignal (low) über die Meldeleitung 18 geliefert wird, kann dies ein Hinweis auf eine Störung im Leitungssystem, welches zur Wandlerversorgung und/oder Sensorversorgung dient, hinweisen. Auch dieses Signal wird im Speicher 23 entsprechend gespeichert. Bei Vorliegen eines Fehlers im Fehlerspeicher 23, welcher mit einer an das Steuergerät 13 angeschlossenen Fehleranzeigeeinrichtung 19 verbunden ist, wird in Abhängigkeit vom ersten oder zweiten Meldesignal eine entsprechende Fehlermeldung gegeben. Gegebenenfalls kann eine Sperre-/Freigabeschaltung 24 zur Sperrung der Steuergerätefunktion, welche mit dem Speicher 23 verbunden sein kann, aktiviert werden. Falls erforderlich, kann über eine Schaltlogik 25 ein Schalter 28 in der Wandlerversorgungsleitung 21 geöffnet werden, so dass der Sensorbetrieb unterbrochen wird.

Falls die Meldeleitung 18 das dritte Meldesignal, welches vorzugsweise zwischen dem Wandlerversorgungs-Potential und Masse-Potential getaktet ist, liefert, zeigt dies den normalen Sensorbetrieb an. Die Steuergerätefunktion wird freigegeben oder fortgesetzt.

Ferner kann überprüft werden, ob die Meldeleitung 18 in funktionsfähigem Zustand ist. Hierzu wird vor dem Zuschalten des Sensors 17 durch Schließen des Schalters 28 das Potential der Meldeleitung 18 geprüft. Wenn dieses Potential auf Masse (0 V)-Potential liegt, wird durch Freigabe der Steuergerätefunktion über die Schaltlogik 25 der Schalter 28 in der Wandlerversorgungsleitung 21 geschlossen. Dabei wird bei korrekter Sensorversorgung innerhalb des Bereiches von 9V bis 14V die Meldeleitung 18 mit dem getakteten Wechselsignal (drittes Meldesignal) belegt, so dass die Steuergerätefunktion durch die Sperre-/Freigabeschaltung 24 freigegeben ist.

Jede Zerstörung der Meldeleitung 18, beispielsweise durch Kurzschluss gegen Massepotential der Masseleitung 20, gegen die Netzspannung oder durch Kabelbruch führt zum Umschalten des getakteten Wechselsignals auf das entsprechende Konstantpotential des ersten oder zweiten Meldesignals. Diese werden, wie oben erläutert, im Steuergerät 13 ausgewertet.

Die Auswertung der von der Meldeleitung 18 gelieferten Störsignale (erstes Meldesignal oder zweites Meldesignal) kann ferner zum Abschalten der Fahrdynamikregelung (ESP) führen. Außerdem kann dem elektronischen Bremssystems eine Fehlermeldung gegeben werden. Es handelt sich hier um weitere sicherheitskritische Funktion des Steuergerätes 13.

### Bezugszeichenliste

- 10: überwachende Spannungswandlereinrichtung
- 11: Auswerteeinrichtung
- 12: Spannungswandler
- 13: Steuergerät
- 15: Frequenzgenerator
- 16: Auswerteeinrichtung
- 17: Sensor
- 18: Meldeleitung
- 19: Fehleranzeigeeinrichtung
- 20: Masseleitung
- 21: Wandlerversorgungsleitung
- 22: Sensorversorgungsleitung
- 23: Speicher für Fehlerbehandlung
- 24: Sperre-/Freigabeschaltung
- 25: Schaltlogik
- 26: Sensorsignalleitung
- 27: Schaltausgang, elektronischer Schalter
- 28: Schalter
- 29: Pulldown Widerstand

## Patentansprüche

1. Verfahren zur Versorgung eines Sensors in einem Fahrzeug mit einer geregelten Sensorversorgungsspannung (22), wobei die Sensorversorgungsspannung (22) ausgewertet wird, und ein erstes Meldesignal bei einem Überschreiten und ein zweites Meldesignal bei einem Unterschreiten eines vorbestimmten Betriebsbereichs der Sensorversorgungsspannung (22) erzeugt wird, und ein drittes Signal erzeugt wird, wenn die Sensorversorgungsspannung (22) innerhalb ihres vorbestimmten Betriebsbereiches liegt, **dadurch gekennzeichnet, dass** das dritte Signal ein mit einer bestimmten Frequenz zwischen den Signalpegeln des ersten und zweiten Meldesignals getaktetes Signal ist.

2. Verfahren nach Anspruch 1, **dadurch gekennzeichnet, dass** das erste Meldesignal einen hohen Potentialpegel und das zweite Signal einen niedrigen Potentialpegel aufweisen.

3. Verfahren nach Anspruch 1 oder 2, **dadurch gekennzeichnet, dass** die Sensorversorgungsspannung am Ausgang eines Spannungswandlers, welcher von einer Wandlerversorgungsspannung betrieben wird, geliefert wird und dass der Signalpegel des ersten Meldesignals im wesentlichen der Wandlerversorgungsspannung und der Signalpegel des zweiten Meldesignals Massepotential entsprechen.

4. Vorrichtung zur Versorgung eines Sensors in einem Fahrzeug mit einer von einem Spannungswandler (12) gelieferten Sensorversorgungsspannung (22), wobei an den Ausgang des Spannungswandlers (12) eine Auswerteeinrichtung (11) angeschlossen ist, die bei Überschreiten eines vorbestimmten Betriebsbereichs der Sensorversorgungsspannung (22) ein erstes Meldesignal und bei Unterschreiten des vorbestimmten Betriebsbereichs der Sensorversorgungsspannung (22) ein zweites Meldesignal und bei innerhalb des Betriebsbereiches liegender Sensorversorgungsspannung (22) ein drittes Meldesignal in einer Meldeleitung (18) bereitstellt, wobei bei den ersten beiden Meldesignalen über ein Steuergerät (13) und einem Fehlerspeicher (23) eine Sperrung veranlasst wird und durch das dritte Meldesignal das Steuergerät (13) den weiteren Sensorbetrieb veranlasst, **dadurch gekennzeichnet, dass** die Meldeleitung (18) beim ersten Meldesignal auf etwa das Potential der Wandlerversorgungsspannung und beim zweiten Meldesignal auf etwa Masse 0 V-Potential durch die Auswerteeinrichtung (11) geschaltet ist und beim dritten Meldesignal mittels eines Frequenzgenerators (15) zwischen dem Potential der Wandlerversorgungsspannung und dem Masse 0 V-Potential getaktet ist.

5. Vorrichtung zur Versorgung eines Sensors nach Anspruch 4, **dadurch gekennzeichnet, dass** das Steuergerät (13) eine Auswerteeinrichtung (16) aufweist, welche die Einschaltung der Wandlerspannung nur dann aktiviert, wenn die Meldeleitung (18) auf Masse (0 V)-Potential liegt.

6. Vorrichtung nach einem der Ansprüche 4 bis 5, **dadurch gekennzeichnet, dass** der Sensor (17) ein Sensor für Prozessgrößen ist.

7. Vorrichtung nach einem der Ansprüche 4 bis 6, **dadurch gekennzeichnet, dass** der Sensor (17) in einem Nutzfahrzeug eingebaut ist.

8. Vorrichtung nach einem der Ansprüche 4 bis 7, **dadurch gekennzeichnet, dass** der Sensor (17) ein Lenkwinkelsensor ist.

## Claims

1. Method for supplying a sensor in a vehicle with a regulated sensor supply voltage (22), whereby the sensor supply voltage (22) is evaluated and an initial status signal is generated when a predefined operating range for the sensor supply voltage (22) is exceeded and a second status signal is generated when the predefined operating range is not reached, and a third signal is generated if the sensor supply voltage (22) lies within its predefined operating range, **characterised in that** the third signal is a pulsed signal with a specified frequency between the signal levels of the first and second status signals.

2. Method in accordance with claim 1, **characterised in that** the first status signal provides a high potential level and the second signal provides a low potential level.

3. Method in accordance with claim 1 or 2, **characterised in that** the sensor supply voltage is supplied at the output of a voltage converter, which voltage converter is operated with a converter supply voltage, and that the signal level of the first status signal essentially corresponds to the converter supply voltage and the signal level of the second status signal corresponds to the earth potential.

4. Device for supplying a sensor in a vehicle with a sensor supply voltage (22) supplied by a voltage converter (12), whereby an evaluation unit (11) is connected to the output of the voltage converter (12), which evaluation unit provides in a status line a first status signal (18) if a predefined operating range for the sensor supply voltage (22) is exceeded and a second status signal if the predefined operating range for the sensor supply voltage (22) is not reached and a third status signal if the sensor supply voltage (22) lies within the operating range, whereby a blockage is initiated with the first two status signals via a control unit (13) and a fault memory (23) and by means of the third status signal, the control unit (13) initiates the further sensor operation, **characterised in that** the status line (18) is switched by the evaluation unit (11) at the first status signal to approximately the potential of the converter supply voltage and, at the second status signal, to approximately earth 0 V potential and, at the third status signal, the potential is pulsed between the potential of the converter supply voltage and earth 0 V potential using a frequency generator (15).

5. Device for supplying a sensor in accordance with claim 4 (12), **characterised in that** the control unit (13) features an evaluation unit (16), which evaluation unit activates the switch-on of the converter voltage only when the status line (18) stands at earth 0 V potential.

6. Device in accordance with one of claims 4 to 5, **characterised in that** the sensor (17) is a sensor for process variables.

7. Device in accordance with one of claims 4 to 6, **characterised in that** the sensor (17) is fitted in a commercial vehicle.

8. Device in accordance with one of claims 4 to 7, **characterised in that** the sensor (17) is a steering angle sensor.

## Revendications

1. Procédé pour alimenter un capteur dans un véhicule à une tension d'alimentation de capteur régulée (22), auquel cas la tension d'alimentation du capteur (22) est analysée, et un premier signal d'état est émis lors d'un dépassement vers le haut et un deuxième signal d'état lors d'un dépassement vers le bas d'une plage de service prédéterminée de la tension d'alimentation du capteur (22), et un troisième signal est émis si la tension d'alimentation du capteur (22) se situe dans sa plage de service prédéterminée, **caractérisé en ce que** le troisième signal est un signal cadencé avec une fréquence définie entre les niveaux de signal du premier et du deuxième signal d'état.

2. Procédé selon la revendication 1, **caractérisé en ce que** le premier signal d'état présente un niveau de potentiel élevé et le deuxième signal un niveau de potentiel faible.

3. Procédé selon la revendication 1 ou 2, **caractérisé en ce que** la tension d'alimentation du capteur est fournie à la sortie d'un transformateur de tension qui fonctionne à une tension d'alimentation de transformateur et **en ce que** le niveau de signal du premier signal d'état correspond pour l'essentiel à la tension d'alimentation du transformateur et le niveau de signal du deuxième signal d'état correspond au potentiel de masse.

4. Dispositif pour alimenter un capteur dans un véhicule à une tension d'alimentation de capteur (22) fournie par un transformateur de tension (12), auquel cas un dispositif d'analyse (11) est raccordé à la sortie du transformateur de tension (12) et met à disposition un premier signal d'état lors du dépassement vers le haut d'une plage de service prédéterminée de la tension d'alimentation du capteur (22), un deuxième signal d'état en cas de dépassement vers le bas de la plage de service prédéterminée de la tension d'alimentation du capteur (22) et un troisième signal d'état dans une ligne d'état (18) dans le cas où la tension d'alimentation du capteur (22) se situe dans la plage de service, auquel cas, dans le cas des deux premiers signaux d'état, un blocage est déclenché via un boîtier électronique (13) et une mémoire des erreurs (23) et le boîtier électronique (13) déclenche la poursuite du fonctionnement du capteur par le troisième signal d'état, **caractérisé en ce que** la ligne d'état (18) est commutée, dans le cas du premier signal d'état, par exemple sur le potentiel de la tension d'alimentation du transformateur et, dans le cas du deuxième signal d'état, par exemple sur le potentiel de masse de 0 V par le dispositif d'analyse (11) et, dans le cas du troisième signal d'état, est cadencée entre le potentiel de la tension d'alimentation du transformateur et le potentiel de masse de 0 V au moyen d'un générateur de fréquence (15).

5. Dispositif pour alimenter un capteur selon la revendication 4, **caractérisé en ce que** le boîtier électronique (13) présente un dispositif d'analyse (16) qui n'active alors la mise en circuit de la tension du transformateur que si la ligne d'état (18) se trouve sur le potentiel de masse (0 V).

6. Dispositif selon l'une des revendications 4 à 5, **caractérisé en ce que** le capteur (17) est un capteur de valeurs de processus.

7. Dispositif selon l'une des revendications 4 à 6, **caractérisé en ce que** le capteur (17) est monté dans un véhicule industriel.

8. Dispositif selon l'une des revendications 4 à 7, **caractérisé en ce que** le capteur (17) est un capteur d'angle de braquage.
